# EUROPÄISCHE PATENTSCHRIFT

(11) **EP 3 414 625 B1**
(45) Veröffentlichungstag und Bekanntmachung des Hinweises auf die Patenterteilung: **08.01.2020**
(21) Anmeldenummer: 17705317.0
(22) Anmeldetag: 27.01.2017
(51) Int. Cl.: G03F 7/20, G01M 11/02

(54) **VORRICHTUNG UND VERFAHREN ZUR MOIRÉ-VERMESSUNG EINES OPTISCHEN PRÜFLINGS**
DEVICE AND METHOD FOR MOIRÉ MEASUREMENT OF AN OPTICAL TEST SPECIMEN
DISPOSITIF ET PROCÉDÉ DE MESURE DE MOIRAGE D'UN ÉCHANTILLON OPTIQUE

(30) Priorität: 12.02.2016 DE 102016202198
(43) Veröffentlichungstag der Anmeldung: 19.12.2018
(73) Patentinhaber: Carl Zeiss SMT GmbH, 73447 Oberkochen (DE)
(72) Erfinder: SAMANIEGO, Michael, 73447 Oberkochen (DE); SCHADE, Peter, 67098 Bad Dürkheim (DE); KEIL, Michael, 73431 Aalen (DE); JÄNKER, Bernd, 73430 Aalen (DE)
(74) Vertreter: Frank, Hartmut
(86) Internationale Anmeldenummer: PCT/EP2017/051759
(87) Internationale Veröffentlichungsnummer: WO 2017/137266

(56) Entgegenhaltungen:
- EP-A2- 0 418 054
- US-A1- 2011 063 592
- US-A1- 2014 347 654

## Beschreibung

Die vorliegende Anmeldung beansprucht die Priorität der Deutschen Patentanmeldung DE 10 2016 202 198.2, angemeldet am 12. Februar 2016.

### HINTERGRUND DER ERFINDUNG

### Gebiet der Erfindung

Die Erfindung betrifft eine Vorrichtung und ein Verfahren zur Moire-Vermessung eines optischen Prüflings.

### Stand der Technik

Mikrolithographie wird zur Herstellung mikrostrukturierter Bauelemente, wie beispielsweise integrierter Schaltkreise oder LCD's, angewendet. Der Mikrolithographieprozess wird in einer sogenannten Projektionsbelichtungsanlage durchgeführt, welche eine Beleuchtungseinrichtung und ein Projektionsobjektiv aufweist. Das Bild einer mittels der Beleuchtungseinrichtung beleuchteten Maske (= Retikel) wird hierbei mittels des Projektionsobjektivs auf ein mit einer lichtempfindlichen Schicht (Photoresist) beschichtetes und in der Bildebene des Projektionsobjektivs angeordnetes Substrat (z.B. ein Siliziumwafer) projiziert, um die Maskenstruktur auf die lichtempfindliche Beschichtung des Substrats zu übertragen.

In der Praxis besteht ein Bedarf, Abbildungsfehler wie z.B. die Verzeichnung des Projektionsobjektivs möglichst exakt zu bestimmen. Hierzu ist insbesondere die Technik der Moire-Vermessung bekannt, bei welcher ein in einer Objektebene des Projektionsobjektivs angeordnetes erstes Gitter auf ein in der Bildebene des Projektionsobjektivs angeordnetes zweites Gitter (auch als "Moiré-Maske" bezeichnet) projiziert und die jeweils durch diese Anordnung transmittierte Lichtintensität mit einer (z.B. kamerabasierten) Detektoranordnung gemessen wird.

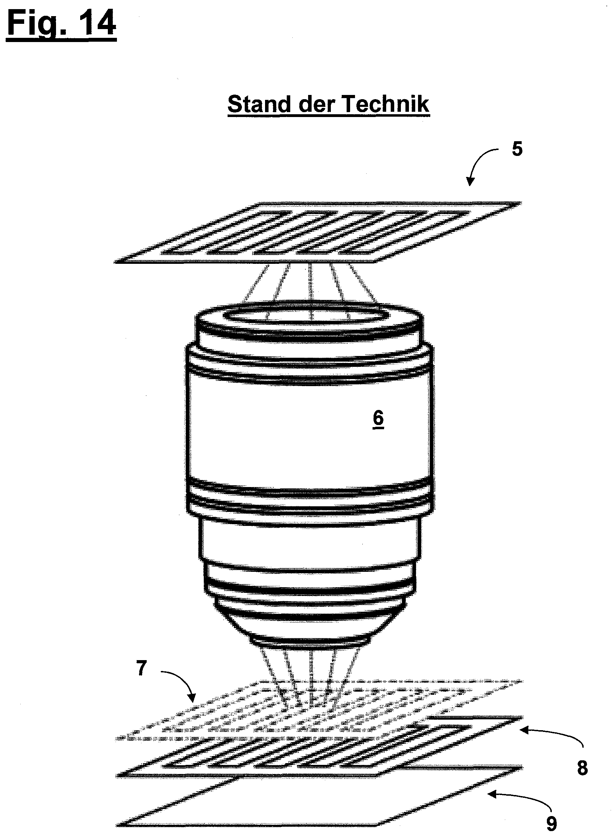

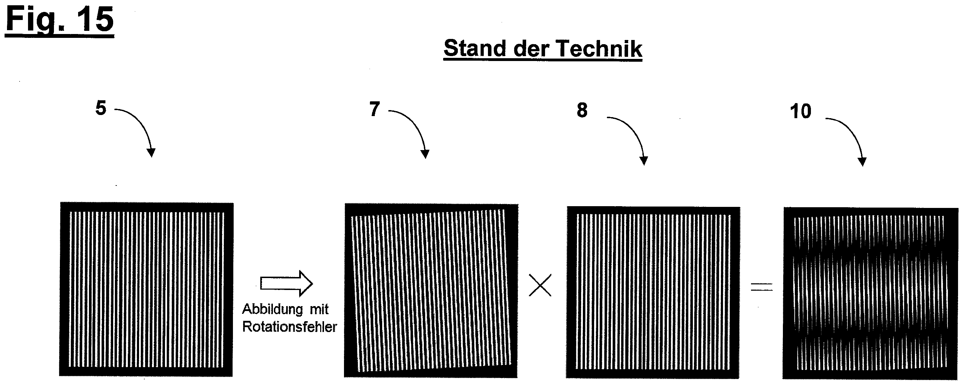

Fig. 14 und 15 zeigen lediglich schematische Darstellungen zur Erläuterung dieses Prinzips. Dabei ist das in der Objektebene des Prüflings in Form eines Projektionsobjektivs 6 befindliche erste Gitter mit "5", das erzeugte Bild der in dem ersten Gitter 5 enthaltenen Teststrukturen mit "7" und das zweite Gitter bzw. die Moire-Maske mit "8" bezeichnet. In der Regel fallen die Ebenen des Teststrukturbildes 7 einerseits und des zweiten Gitters 8 bzw. der Moire-Maske andererseits zusammen und sind in Fig. 14 lediglich zur besseren Darstellung räumlich getrennt dargestellt. Über eine Detektoranordnung 9 wird die in Lichtausbreitungsrichtung nach dem zweiten Gitter 8 bzw. der Moire-Maske erhaltene Lichtverteilung 10 (welche gemäß Fig. 15 typischerweise ein charakteristisches Streifenmuster aufweist) bestimmt. Dabei ist bei entsprechender Auslegung der Gitteranordnung aus dem ersten und zweiten Gitter die transmittierte Lichtintensität im Falle einer fehlerfreien Abbildung maximal und im Falle vorhandener Abbildungsfehler des Projektionsobjektivs 6 reduziert, da das Licht von hellen Bereichen der in dem ersten Gitter 5 enthaltenen Teststrukturen bei fehlerhafter Abbildung in zunehmenden Maße auf dunkle Bereiche des zweiten Gitters 8 bzw. der Moire-Maske fällt.

Zur Ermittlung der jeweils relevanten Abbildungsfehler des Prüflings bzw. Projektionsobjektivs sind unterschiedliche Mess- und Auswerteverfahren auf Basis der Moire-Vermessung bekannt. Diesen Mess- bzw. Auswerteverfahren ist gemeinsam, dass für einzelne Feldpunkte herangezogene Signale jeweils auf Basis einer Mittelung über einen bestimmten Bereich erhalten werden. Dabei sind wiederum Signale an mehreren Feldpunkten wünschenswert, um den Feldverlauf von Abbildungsfehlern wie z.B. der Verzeichnung bestimmen zu können.

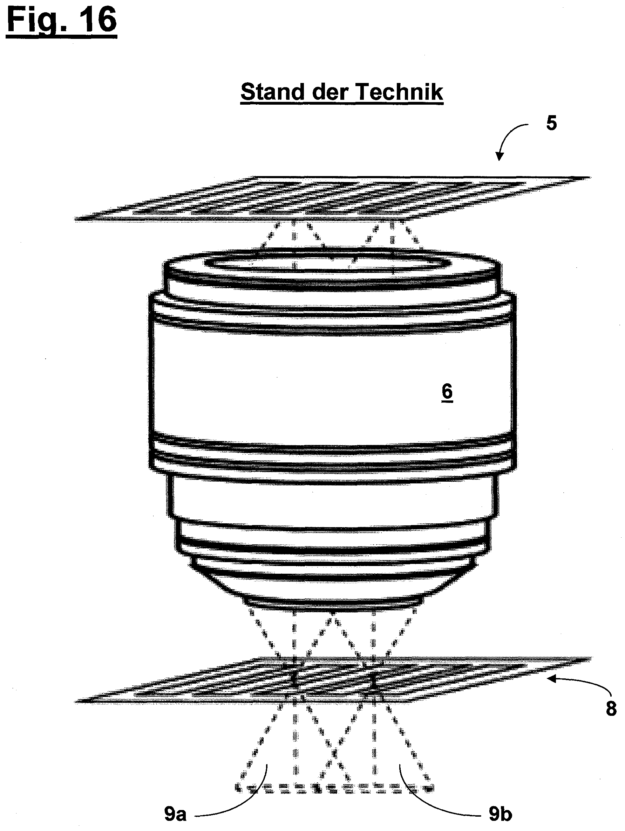

Ein hierbei in der Praxis auftretendes Problem ist jedoch, dass - wie in Fig. 16 angedeutet - aufgrund der Winkelverteilung des aus dem Prüfling bzw. Projektionsobjektiv 6 bzw. der Moire-Maske 8 austretenden Lichtes eine Überlappung der jeweiligen, unterschiedlichen Feldpunkten zugeordneten Lichtkegel (in Fig. 16 mit "9a" und "9b" bezeichnet) stattfinden kann mit der Folge, dass in der jeweiligen Detektionsebene das jeweils zur Auswertung unterschiedlicher Feldpunkte herangezogene Licht zum Teil zusammenfällt. Ursachen für diesen Effekt sind u.a. die aufgrund der Winkelverteilung des aus dem Prüfling austretenden Lichts vorhandene Lichtdivergenz, die durch Beugung an der Moire-Maske entstehende Lichtdivergenz sowie auch die Divergenz aufgrund möglichen Streulichts.

Die Erzielung einer möglichst hohen Feldauflösung bei der Moire-Vermessung ist jedoch insbesondere wünschenswert, wenn in einem vergleichsweise schmalen Bildfeld - wie es etwa durch ein für den Betrieb im EUV ausgelegtes Projektionsobjektiv erzeugt wird - noch möglichst viele voneinander unabhängige Messsignale zur Ermittlung z.B. eines Feldverlaufs der Verzeichnung bestimmt werden sollen.

US 2011/063592 A1 offenbart u.a. eine Vorrichtung zur Moire-Vermessung eines Projektionsobjektivs einer mikrolithographischen Projektionsbelichtungsanlage mit einem im optischen Strahlengang vor dem zu untersuchenden Projektionsobjektiv positionierten ersten Gitter und einem im Strahlengang nach dem Projektionsobjektiv angeordneten zweiten Gitter, wobei ferner eine Anordnung von Lichtleitern zwischen dem zweiten Gitter und einer Bilderfassungs- bzw. Detektorvorrichtung angeordnet ist.

US 2014/347654 A1 offenbart u.a. eine Vorrichtung und ein Verfahren zur Vermessung der Abbildungsqualität eines Projektionsobjektivs unter Nutzung des Moire-Effekts, wobei in Ausführungsformen eine Blendenstruktur in der Bildebene angeordnet wird, um den Einfluss von Streulicht auf die Messung zu reduzieren.

EP 0 418 054 A2 offenbart u.a. eine Vorrichtung zur Moire-Vermessung eines Projektionsobjektivs, wobei in der Pupillenebene des Projektionsobjektivs ein Filter angeordnet werden kann, um von dem vom ersten Beugungsgitter ausgehenden Licht sämtliche Beugungsordnungen außer der ±1. Beugungsordnung zu blockieren.

### ZUSAMMENFASSUNG DER ERFINDUNG

Vor dem obigen Hintergrund ist es eine Aufgabe der vorliegenden Erfindung, eine Vorrichtung und ein Verfahren zur Moire-Vermessung eines optischen Prüflings bereitzustellen, welche eine verbesserte Feldauflösung bei der Ermittlung von Abbildungsfehlern des Prüflings ermöglichen.

Diese Aufgabe wird durch die Anordnung gemäß den Merkmalen des unabhängigen Patentanspruchs 1 bzw. das Verfahren gemäß den Merkmalen des nebengeordneten Anspruchs 14 gelöst.

Eine Vorrichtung zur Moire-Vermessung eines optischen Prüflings weist auf:
- einer Gitteranordnung aus einem ersten, im optischen Strahlengang vor dem Prüfling positionierbaren Gitter und einem zweiten, im optischen Strahlengang nach dem Prüfling positionierbaren Gitter,
- einer Auswerteeinheit mit wenigstens einem Detektor zur Auswertung von durch Überlagerung der beiden Gitter in einer im optischen Strahlengang nach dem zweiten Gitter befindlichen Detektionsebene erzeugten Moire-Strukturen; und
- wenigstens einer Aperturblende, durch welche die nach Lichtaustritt aus dem zweiten Gitter entstandene Lichtverteilung derart bereichsweise abgeschattet werden kann, dass nur Licht einer Untermenge aller Feldpunkte auf dem zweiten Gitter die Detektionsebene erreicht.

Der Erfindung liegt insbesondere das Konzept zugrunde, in einer Vorrichtung zur Moire-Vermessung eines optischen Prüflings wie z.B. eines Projektionsobjektivs einer mikrolithographischen Projektionsbelichtungsanlage über eine Aperturblende die nach Lichtaustritt aus der Moire-Maske bzw. dem zweiten Gitter entstandene Lichtverteilung bereichsweise abzuschatten, so dass jeweils nur Licht einer Untermenge aller Feldpunkte den Detektor erreicht. Dabei kann die Auswahl der in einer Position der Aperturblende messbaren Feldpunkte so gewählt sein, dass sich von unterschiedlichen Feldpunkten ausgehendes Licht nicht überlagern kann (wobei z.B. in einer Einstellung nur jeder zweite, jeder dritte oder jeder vierte Feldpunkt erfasst wird).

Dabei ist die Aperturblende vorzugsweise derart ausgestaltet, dass die betreffende Untermenge aller Feldpunkte auf dem zweiten Gitter, welche jeweils die Detektionsebene erreicht, variabel einstellbar ist. Auf diese Weise kann im Wege einer Durchführung mehrerer Messungen nacheinander (z.B. unter Verschiebung der Aperturblende in jeweils unterschiedliche Messstellungen) eine Erfassung sämtlicher Feldpunkte in einer sequentiellen Messreihe realisiert werden.

Hierdurch kann im Ergebnis die unerwünschte Überlagerung der von unterschiedlichen Feldpunkten des zweiten Gitters bzw. der Moire-Maske im optischen Strahlengang ausgehenden Lichtkegel und damit die unerwünschte Vermischung der diesen Feldpunkten jeweils zugeordneten Informationen vermieden und dennoch - im Wege der Durchführung einer Mehrzahl sequentieller Messschritte - für unterschiedliche Positionen der Aperturblende bzw. unterschiedliche hierdurch bewirkte Abschattungen letztlich ebenfalls die jeweils gewünschte Gesamtzahl von Messpunkten unter Erfassung sämtlicher Feldpunkte auf dem zweiten Gitter erzielt werden.

Zugleich wird aufgrund des Umstandes, dass besagte Vermeidung der Überlappung der besagten Lichtkegel bzw. Vermischung der zu unterschiedlichen Feldpunkten der Moire-Maske gehörenden Informationen durch jeweils unterschiedliche Abschattungen in mehreren Messschritten erreicht wird, die Anforderung nach einer möglichst nahen Heranführung der Detektionsebene an das zweite Gitter bzw. die Moire-Maske reduziert. Mit anderen Worten kann aufgrund der erfindungsgemäßen Verwendung einer Aperturblende die besagte Vermischung der unterschiedlichen Feldpunkten zugeordneten Lichtkegel auch noch bei vergleichsweise größeren Abständen zwischen Moire-Maske und Detektionsebene verhindert werden.

Gemäß einer Ausführungsform ist die Aperturblende durch Verschiebung quer zur Lichtausbreitungsrichtung und/oder durch Verdrehung um eine zur Lichtausbreitungsrichtung parallele Achse verstellbar.

Gemäß einer Ausführungsform ist die Aperturblende aus einer Mehrzahl von Aperturblenden, welche sich hinsichtlich der jeweils in derselben Position bewirkten Abschattung voneinander unterscheiden, auswählbar. Die Aperturblende ist somit entsprechend austauschbar im optischen Strahlengang angeordnet. Eine solche Verwendung unterschiedlicher Aperturblenden in einer Mehrzahl von Messschritten hat im Vergleich zur Verwendung ein- und derselben, lediglich zwischen aufeinanderfolgenden Messschritten in ihrer Position veränderten Aperturblende den Vorteil, dass zugleich in einfacher Weise eine Kalibrierung bzw. Korrektur etwaiger Offsets realisiert werden kann, indem nämlich übereinstimmende Feldpunkte zweier unterschiedlicher Aperturblenden jeweils als "Kalibrierstellen" genutzt werden können.

Gemäß einer Ausführungsform ist die Aperturblende oder deren im optischen Strahlengang erzeugtes Bild von dem zweiten Gitter um weniger als 100µm, insbesondere weniger als 80µm, weiter insbesondere weniger als 60µm, entfernt.

Die Aperturblende kann insbesondere zwischen dem zweiten Gitter und dem Detektor angeordnet sein. Die Erfindung ist jedoch nicht hierauf beschränkt. Vielmehr kann die Aperturblende in weiteren Ausführungsformen auch bezogen auf die Lichtausbreitungsrichtung unmittelbar vor der Moire-Maske bzw. dem zweiten Gitter oder auch unmittelbar vor oder nach dem ersten Gitter angeordnet sein. Des Weiteren kann das vorstehende Kriterium, wonach das im optischen Strahlengang erzeugte Bild der Aperturblende von dem zweiten Gitter um weniger als 100µm entfernt ist, auch durch Anordnung der Aperturblende im Bereich einer Zwischenbildebene des Prüflings bzw. Projektionsobjektivs oder der im Strahlengang vor diesem angeordneten Beleuchtungseinrichtung realisiert werden. Dabei hat die Platzierung der Aperturblende im Bereich einer Zwischenbildebene den Vorteil, dass das vorstehend genannte Abstandskriterium vergleichsweise einfach zu erfüllen ist, da sich in besagter Zwischenbildebene in der Regel kein weiteres optisches Element befindet.

Gemäß einer Ausführungsform weist die Detektionsebene einen Abstand zu dem zweiten Gitter von weniger als 100µm, insbesondere weniger als 80µm, weiter insbesondere weniger als 60µm, weiter insbesondere weniger als 40µm, weiter insbesondere weniger als 10µm, weiter insbesondere weniger als 5µm, weiter insbesondere weniger als 1µm, weiter insbesondere weniger als 200nm, auf.

Gemäß dieser Ausführungsform wird somit der Abstand zwischen der Moire-Maske (d.h. dem im optischen Strahlengang nach dem Prüfling positionierten zweiten Gitter) und einer im optischen Strahlengang nachfolgenden Detektionsebene (in welcher die auszuwertende Überlagerung der Moire-Maske mit dem im Strahlengang vor dem Prüfling befindlichen ersten Gitter erfolgt) vergleichsweise hinreichend gering gewählt. Hierdurch wird die jeweilige Fläche, auf die sich das Licht aus einem Feldpunkt in der Detektionsebene verteilt, gering gehalten.

Auf diese Weise kann erreicht werden, dass durch die Aperturblende nur ein Teil der Feldpunkte hinsichtlich des von ihnen ausgehenden Lichtes in ein- und demselben Messschritt abgedeckt werden müssen, mit anderen Worten also eine gewisse Anzahl von Feldpunkten auf dem zweiten Gitter gleichzeitig bzw. in ein- und demselben Messschritt gemessen werden können und somit insgesamt eine Reduzierung der benötigten Messzeit erzielt wird.

In einigen entsprechenden, im Weiteren näher beschriebenen Ausführungsformen umfasst die vorliegende Erfindung auch diverse Realisierungen geringer Abstände zwischen Moire-Maske und (z.B. kamerabasiertem) Detektor, wobei jeweils z.B. fertigungstechnische Herausforderungen gelöst werden. In weiteren Ausführungsformen umfasst die vorliegende Erfindung ferner auch Ausgestaltungen mit vergleichsweise großem Abstand zwischen dem eigentlichen (z.B. kamerabasierten) Detektor und der Moire-Maske, wobei bei diesen ebenfalls im weiteren noch näher beschriebenen Ausgestaltungen jeweils eine geeignete optische Signalübertragung von der (wiederum in geringem Abstand zur Moire-Maske angeordneten) Detektionsebene bis zum Detektor realisiert wird. Da bei dieser optischen Signalübermittlung jeweils ein "Übersprechen" zwischen den unterschiedlichen Feldpunkten zugeordneten Signalen vermieden werden kann, kann auch hier im Ergebnis eine hohe Feldauflösung unter Vermeidung der eingangs beschriebenen Probleme realisiert werden.

Im Ergebnis kann so eine hinreichende Feldauflösung bei der Moire-Vermessung des Prüflings erzielt und auch bei besonders schmalen Bildfeldern (etwa im Falle eines für den Betrieb im EUV ausgelegten Projektionsobjektivs) ein Feldverlauf der relevanten Abbildungsfehler wie z.B. Verzeichnung ermittelt werden.

Gemäß einer Ausführungsform ist der optische Prüfling ein Projektionsobjektiv einer mikrolithographischen Projektionsbelichtungsanlage, insbesondere ausgelegt für einen Betrieb bei einer Arbeitswellenlänge von weniger als 30nm, weiter insbesondere ausgelegt für einen Betrieb bei einer Arbeitswellenlänge von weniger als 15nm.

Gemäß einer Ausführungsform weist der Detektor ein Array von Lichtsensoren auf.

Gemäß einer Ausführungsform weist der Detektor eine faseroptisch an die Detektionsebene gekoppelte Sensoranordnung auf.

Gemäß einer Ausführungsform weist die Vorrichtung eine Hilfsoptik zur Abbildung einer in der Detektionsebene erhaltenen Lichtverteilung auf den Detektor auf.

Gemäß einer Ausführungsform weist die Vorrichtung ferner eine Quantenkonverterschicht auf, welche als Primärlicht zur Detektionsebene gelangendes Licht eines ersten Wellenlängenbereichs absorbiert und Sekundärlicht eines von dem ersten Wellenlängenbereich verschiedenen zweiten Wellenlängenbereichs emittiert.

Gemäß einer Ausführungsform besitzt die Quantenkonverterschicht in dem ersten Wellenlängenbereich eine Eindringtiefe von weniger als 10µm, insbesondere weniger als 5µm.

Gemäß einer Ausführungsform weist die Vorrichtung ferner eine Farbfilterschicht auf, welche von der Quantenkonverterschicht nicht absorbiertes Licht wenigstens teilweise herausfiltert.

Die Erfindung betrifft weiter ein Verfahren zur Moire-Vermessung eines optischen Prüflings unter Verwendung einer Vorrichtung mit den vorstehend beschriebenen Merkmalen, wobei über die wenigstens eine Aperturblende in einer Mehrzahl von Messschritten die nach Lichtaustritt aus dem zweiten Gitter entstandene Lichtverteilung derart bereichsweise abgeschattet wird, dass jeweils nur Licht einer Untermenge aller Feldpunkte auf dem zweiten Gitter die Detektionsebene erreicht.

Gemäß einer Ausführungsform wird durch Überführung der Aperturblende in unterschiedliche Messstellungen und/oder durch Austausch der Aperturblende eine Erfassung sämtlicher Feldpunkte in einer sequentiellen Messreihe realisiert.

Zu Vorteilen sowie vorteilhaften Ausgestaltungen des Verfahrens wird auf die vorstehenden Ausführungen im Zusammenhang mit der erfindungsgemäßen Vorrichtung Bezug genommen.

Weitere Ausgestaltungen der Erfindung sind der Beschreibung sowie den Unteransprüchen zu entnehmen.

Die Erfindung wird nachstehend anhand von in den beigefügten Abbildungen dargestellten Ausführungsbeispielen näher erläutert.

### KURZE BESCHREIBUNG DER ZEICHNUNGEN

Es zeigen:
- Figur 1-13: schematische Darstellungen zur Erläuterung unterschiedlicher Ausführungsformen der vorliegenden Erfindung;
- Figur 14-15: schematische Darstellungen zur Erläuterung von Aufbau und Funktionsprinzip einer herkömmlichen Vorrichtung zur MoireVermessung eines optischen Prüflings; und
- Figur 16: eine schematische Darstellung zur Erläuterung eines bei einer herkömmlichen Vorrichtung zur Moire-Vermessung auftretenden Problems.

### DETAILLIERTE BESCHREIBUNG BEVORZUGTER AUSFÜHRUNGSFORMEN

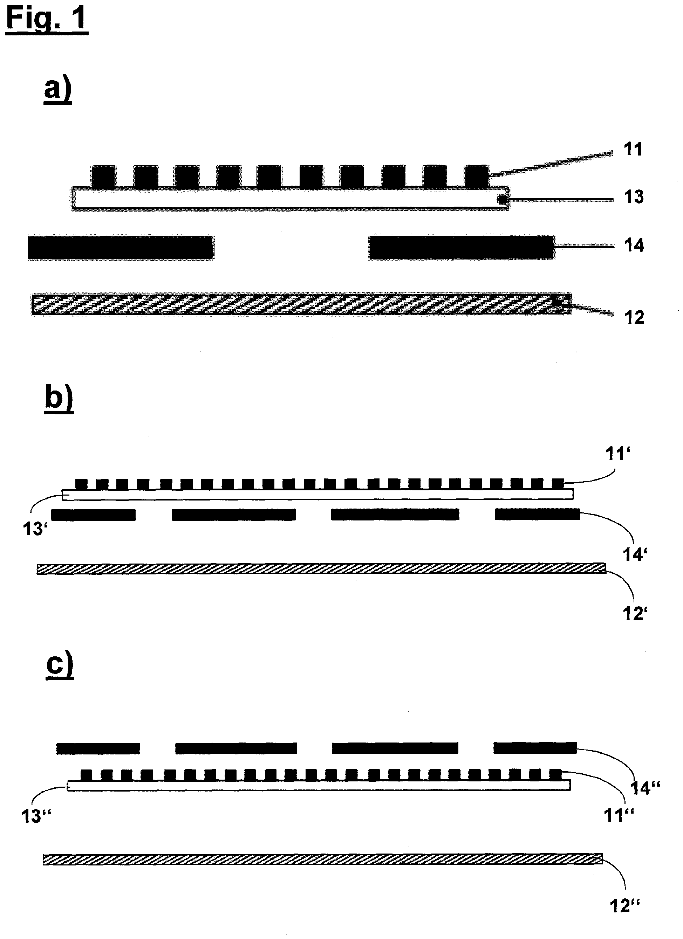

Gemäß Fig. 1a-c ist erfindungsgemäß eine quer zur Lichtausbreitungsrichtung in unterschiedliche Messpositionen verschiebbare Aperturblende 14 (bzw. 14' oder 14" in Fig. 1b bzw. Fig. 1c) vorgesehen.

Über die Aperturblende 14 kann die nach Lichtaustritt aus der Moire-Maske bzw. dem zweiten Gitter 11 entstandene Lichtverteilung bereichsweise abgeschattet werden, so dass jeweils nur Licht einer Untermenge aller Feldpunkte den Detektor 12 erreicht. Dabei kann die Auswahl der in einer Position der Aperturblende 14 messbaren Feldpunkte so gewählt sein, dass sich von unterschiedlichen Feldpunkten ausgehendes Licht nicht überlagern kann (wobei z.B. in einer Einstellung nur jeder zweite, jeder dritte oder jeder vierte Feldpunkt erfasst wird). Im Wege einer Durchführung mehrerer Messungen nacheinander kann durch Verschiebung der Aperturblende 14 in unterschiedliche Messstellungen eine Erfassung sämtlicher Feldpunkte auf der Moire-Maske bzw. dem zweiten Gitter in einer sequentiellen Messreihe realisiert werden.

Diese Aperturblende kann gemäß Fig. 1a,b zwischen Moire-Maske bzw. zweitem Gitter 11 (welches auf einem Substrat 13 ausgebildet ist) und Detektor 12 angeordnet sein und insbesondere gemäß Fig. 1b eine Mehrzahl von Aperturöffungen aufweisen. Gemäß Fig. 1c kann die Aperturblende 14" auch bezogen auf die Lichtausbreitungsrichtung unmittelbar vor der Moire-Maske bzw. dem zweiten Gitter 11" angeordnet sein.

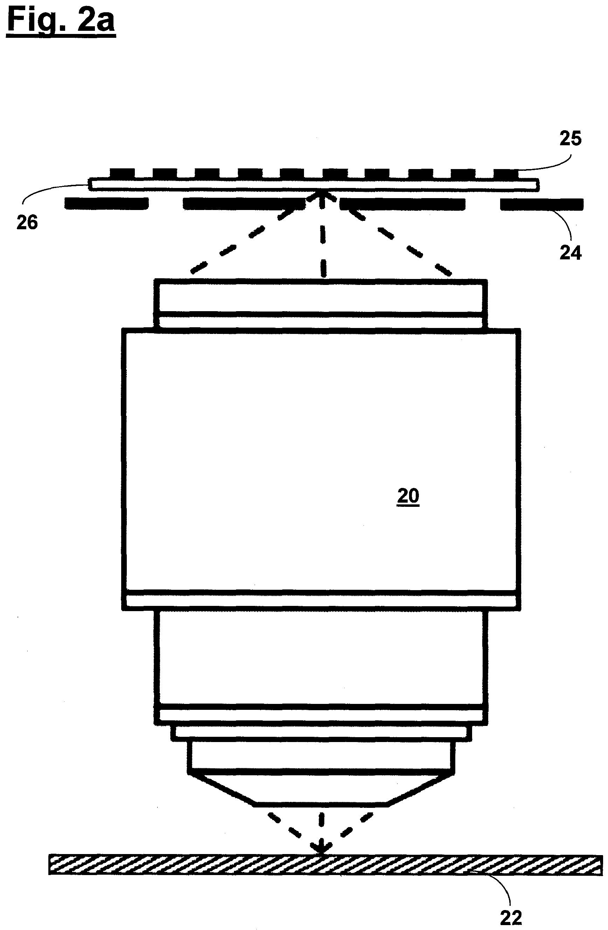

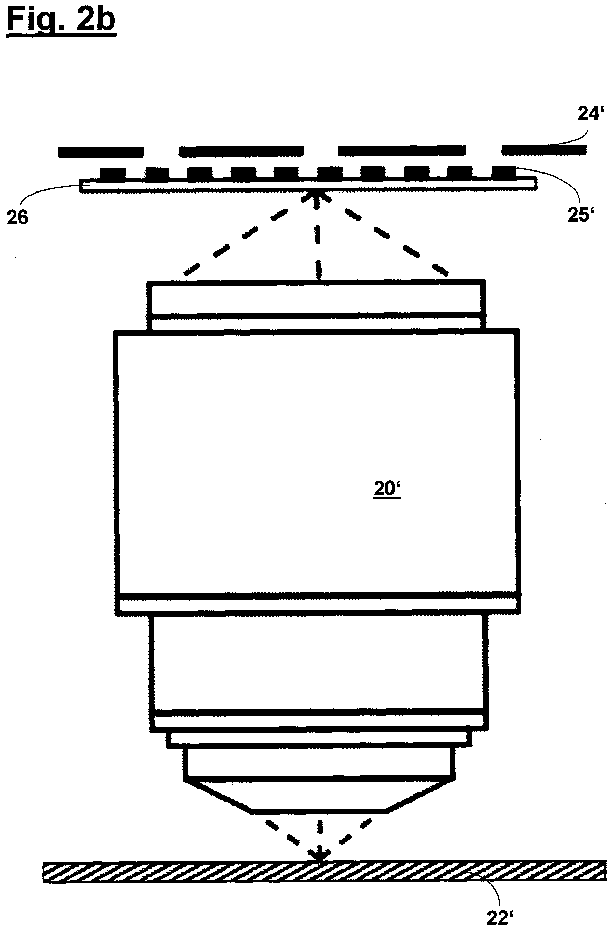

Des Weiteren kann gemäß Fig. 2a-b die Aperturblende 24 bzw. 24' auch bezogen auf die Lichtausbreitungsrichtung unmittelbar nach dem ersten Gitter (Fig. 2a) oder unmittelbar vor dem ersten Gitter (Fig. 2b) angeordnet sein. In Fig. 2ab ist mit "26" bzw. "26"' das Substrat des ersten Gitters, mit "20" bzw. "20' der Prüfling bzw. das Projektionsobjektiv und mit "22" bzw. "22"' der Detektor bezeichnet.

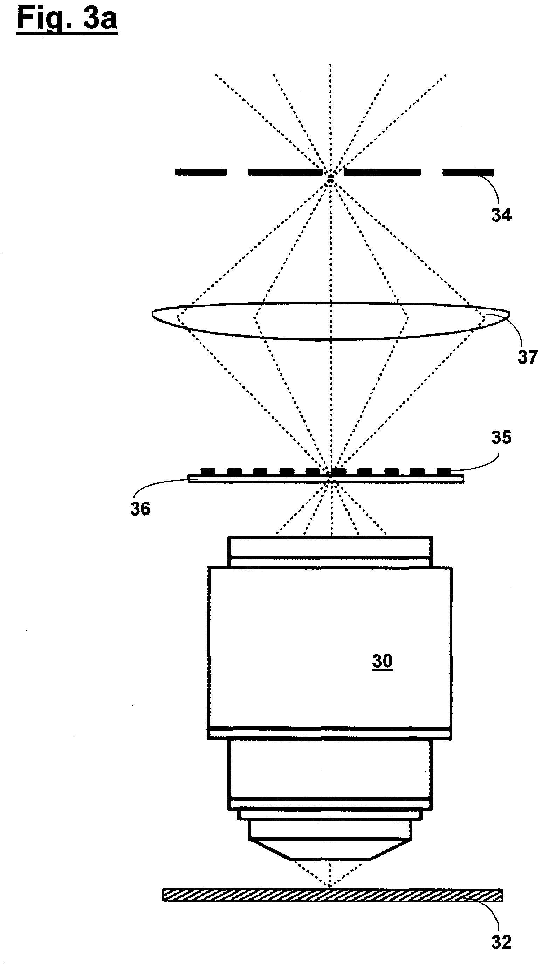

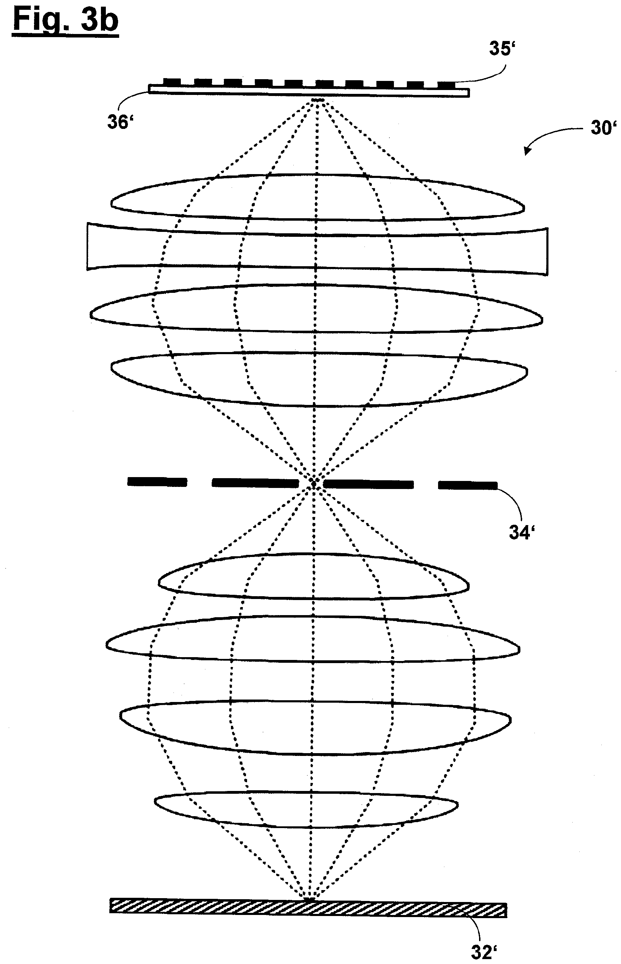

Allgemein ist die Aperturblende oder deren im optischen Strahlengang erzeugtes Bild von dem zweiten Gitter bzw. der Moire-Maske vorzugsweise um weniger als 100µm, insbesondere weniger als 80µm, weiter insbesondere weniger als 60µm, entfernt. In Ausführungsformen der Erfindung kann dieses Abstandskriterium auch durch Anordnung der Aperturblende im Bereich einer Zwischenbildebene realisiert werden, wie in Fig. 3a-b schematisch dargestellt ist. Fig. 3a zeigt die Platzierung einer erfindungsgemäßen Aperturblende 34 in einer Zwischenbildebene innerhalb der vor dem ersten Gitter 35 befindlichen Beleuchtungseinrichtung (von welcher in Fig. 3a lediglich eine Linse 37 angedeutet ist). Im Übrigen sind zu Fig. 2a analoge bzw. im Wesentlichen funktionsgleiche Komponenten in Fig. 3a mit um "10" erhöhten Bezugsziffern bezeichnet. Fig. 3b zeigt ebenfalls schematisch und stark vereinfacht die Platzierung einer erfindungsgemäßen Aperturblende 34' in einer Zwischenbildebene innerhalb des Prüflings bzw. Projektionsobjektivs 30', wobei hier das erste Gitter mit "35""' und der Detektor mit "32"' bezeichnet ist.

Im Weiteren werden jeweils ausgehend von dem prinzipiellen, anhand von Fig. 14-16 beschriebenen Aufbau zur Moire-Vermessung unterschiedliche Ausführungsformen der Erfindung beschrieben, in denen zur Realisierung einer hohen Feldauflösung unter Vermeidung der eingangs beschriebenen Probleme (insbesondere der Überlappung der in Fig. 16 angedeuteten Lichtkegel) jeweils ein geringer Abstand zwischen Detektionsebene und Moire-Maske realisiert wird.

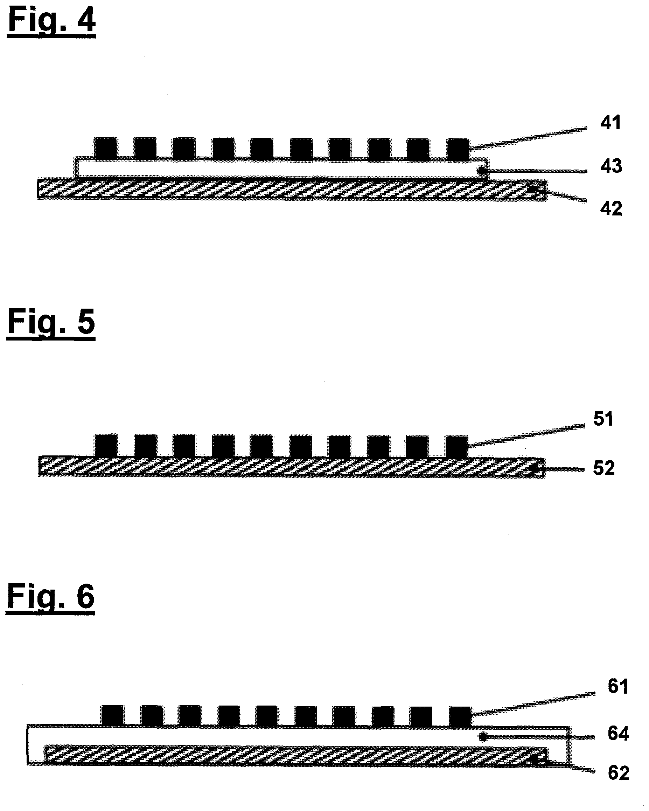

Dies geschieht bei den in Fig. 1-5 dargestellten Ausführungsformen unter Realisierung eines entsprechend geringen Abstandes zwischen dem jeweils eingesetzten (z.B. kamerabasierten) Detektor und der Moire-Maske, wohingegen bei den in Fig. 6-10 dargestellten Ausführungsformen jeweils eine geeignete optische Signalübertragung zwischen der Detektionsebene und dem (in diesen Beispielen von der Moire-Maske weiter entfernten) Detektor verwirklicht wird.

Fig. 4 zeigt zunächst eine Ausführungsform, bei welcher ein zweites Gitter 41 bzw. die Moire-Maske auf einer unmittelbar auf einem Detektor 42 befindlichen Substratfolie 43 aufgebracht ist, so dass der Abstand zwischen Moire-Maske bzw. zweitem Gitter 41 und Detektionsebene hier über die Dicke der Substratfolie 43 eingestellt wird.

Bei der Substratfolie 43 kann es sich z.B. um eine Glasmembran mit einer beispielhaften Dicke von 25µm handeln. Die Substratfolie 43 kann hierbei so ausgelegt sein, dass eine reflexmindernde Wirkung unter Reduzierung unerwünschter Störsignale erzielt wird.

Fig. 5 zeigt eine weitere Ausführungsform, wobei analoge bzw. im Wesentlichen funktionsgleiche Komponenten mit um "10 erhöhten Bezugsziffern bezeichnet sind. Gemäß Fig. 5 ist im Unterschied zu Fig. 1 die Moire-Maske bzw. das zweite Gitter 51 unmittelbar auf der Oberfläche des (im Ausführungsbeispiel als Kamerachip ausgelegten) Detektors 52 aufgebracht. Dabei kann das Aufbringen der Strukturen der Moire-Maske bzw. des zweiten Gitters 51 bereits Bestandteil des Fertigungsprozesses des Detektors 52 bzw. Kamerachips sein.

Fig. 6 zeigt eine weitere Ausführungsform, bei welcher im Unterschied zu Fig. 3 die Aufbringung der Strukturen der Moire-Maske bzw. des zweiten Gitters 61 nicht unmittelbar auf dem Detektor 62 bzw. Kamerachip, sondern auf einer auf dem Detektor 62 befindlichen Schutzschicht 64 erfolgt. Hierdurch kann eine Schädigung des Detektors 62 während des Fertigungsprozesses (welcher einen Lithographieprozess mit Ätzschritten oder ein Elektronenstrahlschreiben umfassen kann) verhindert werden. Dabei kann die Schutzschicht 64 auf der lichtempfindlichen Fläche des Detektors 62 nur bereichsweise oder auch auf der gesamten lichtempfindlichen Fläche des Detektors 62 aufgebracht sein. Ferner kann die Schutzschicht 64 auch ggf. den gesamten Detektor 62 bzw. Kamerachip umhüllen. Die Dicke der Schutzschicht 64 kann in geeigneter Weise gewählt werden, um zum einen den gewünschten Abstand zwischen Moire-Maske bzw. zweitem Gitter 61 und Detektor 62 bzw. Detektionsebene einzustellen und zum anderen auch eine Reflexminderung zur Eliminierung unerwünschter Störsignale zu erzielen. Im Ausführungsbeispiel kann die Schutzschicht 64 aus Quarzglas (SiO₂) hergestellt sein und eine Dicke im Bereich von 20nm bis 200nm aufweisen.

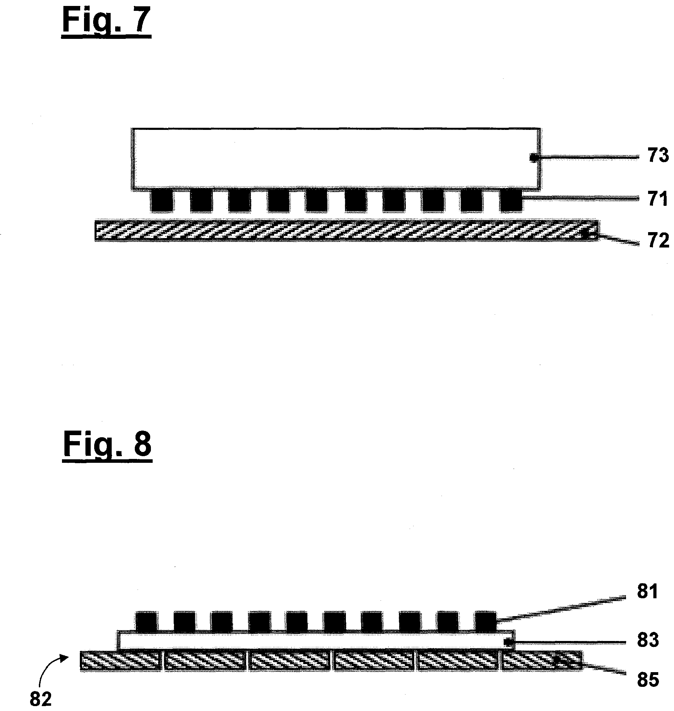

Fig. 7 zeigt eine weitere Ausführungsform, bei welcher im Unterschied zu den vorstehend beschriebenen Ausführungsformen die Moire-Maske bzw. das zweite Gitter 71 auf der dem Detektor 72 abgewandten Seite eines transparenten Substrats 73 angeordnet ist. Infolge dieser Anordnung kann das Substrat 73 selbst - trotz der auch hier erfolgenden Realisierung eines geringen Abstandes zwischen Moire-Maske bzw. zweitem Gitter 71 und Detektionsebene - eine vergleichsweise große Dicke (z.B. von einigen hundert Mikrometern (µm)) aufweisen, womit eine höhere Stabilität der Anordnung realisiert werden kann.

Fig. 8 zeigt eine weitere Ausführungsform, bei welcher der Detektor 85 ein Array von Lichtsensoren wie z.B. Photodioden aufweist, wobei im Übrigen wiederum ein dünnes Substrat 83 zwischen Moire-Maske bzw. zweitem Gitter 81 und dem den Detektor 82 bildenden Array 85 von Lichtsensoren vorgesehen ist. Hierdurch kann die Herstellbarkeit gegenüber einem vollflächigen Kamerachip als Detektor verbessert werden, da eine größere Flexibilität hinsichtlich der jeweils zulässigen Fertigungsschritte erzielt wird.

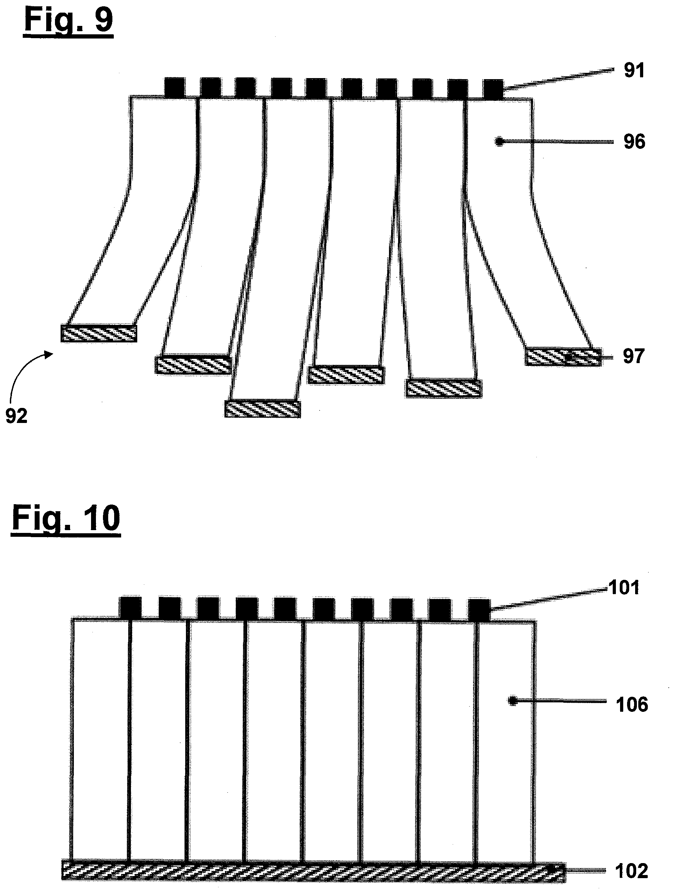

In Fig. 9 und Fig. 10 sind jeweils Ausführungsformen dargestellt, bei welchen der Detektor bzw. eine diesen Detektor bildende Sensoranordnung faseroptisch an die Detektionsebene gekoppelt ist. So erfolgt gemäß Fig. 9 und Fig. 10 jeweils eine Lichtaufnahme unmittelbar nach Lichtaustritt aus der Moire-Maske bzw. dem jeweiligen zweiten Gitter 91 bzw. 101, wobei dann das jeweilige optische Signal über optische Fasern 96 (gemäß Fig. 9) oder eine monolithische Face-Plate 106 (gemäß Fig. 10) bis zu dem jeweiligen Detektor 92 bzw. 102, welcher sich selbst in größerem Abstand von der Moire-Maske befinden kann, geleitet wird. Da das in der Detektionsebene - wiederum nur in geringem Abstand von der Moire-Maske - aufgenommene Licht faseroptisch zu dem jeweiligen Detektor 92 bzw. 102 transportiert wird, tritt kein Mischen bzw. Übersprechen der jeweiligen Signale auf.

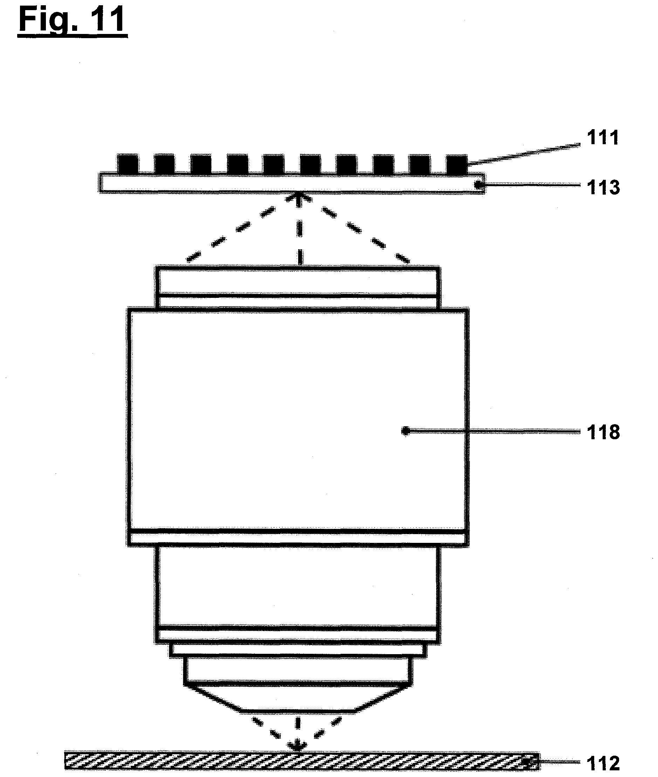

Fig. 11, 12 und 13 zeigen weitere Ausführungsformen, bei denen im Unterschied zu den vorstehend beschriebenen Beispielen jeweils eine Hilfsoptik in Form einer zusätzlichen Projektionsoptik eingesetzt wird, um das in der - wiederum unmittelbar hinter der Moire-Maske liegenden - Detektionsebene aufgefangene Lichtfeld auf den weiter entfernten Detektor 112, 122 bzw. 132 abzubilden. Die Hilfsoptik 118, 128 bzw. 138 ist hierbei jeweils so ausgestaltet, dass sie das volle Winkelspektrum des hinter der Moire-Maske bzw. dem zweiten Gitter 111, 121 bzw. 131 aufgefangenen Lichtes oder zumindest einen repräsentativen Anteil des jeweiligen Winkelspektrums übertragen kann.

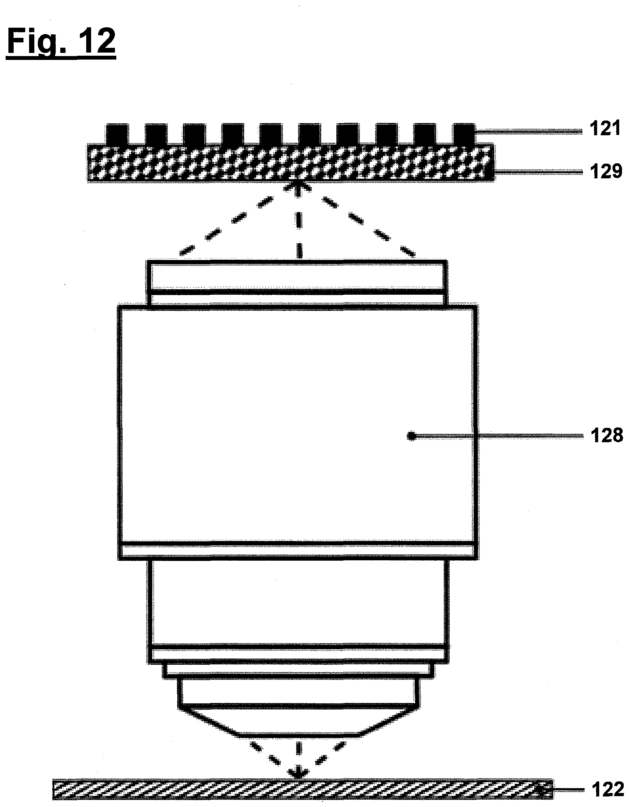

Gemäß Fig. 12 befindet sich im Unterschied zu Fig. 11 die Moire-Maske bzw. das zweite Gitter 121 auf einer Quantenkonverterschicht 129, welche als Primärlicht zur Detektionsebene gelangendes Licht eines ersten Wellenlängenbereichs absorbiert und Sekundärlicht eines zweiten, von dem ersten Wellenlängenbereich verschiedenen Wellenlängenbereichs emittiert.

Im Ausführungsbeispiel kann die Quantenkonverterschicht 129 lediglich beispielhaft aus Lithiumglas hergestellt sein, welches für Wellenlängen unterhalb von 350nm eine Eindringtiefe von weniger als 5µm aufweist und Sekundärlicht in einem Wellenlängenbereich zwischen 360nm und 500nm emittiert. Hierdurch kann erreicht werden, dass die von der Hilfsoptik 128 übertragene Winkelverteilung repräsentativ für die tatsächliche Lichtintensität in der Detektionsebene ist und Beugungseffekte der auf der Moire-Maske befindlichen Strukturen außer Betracht bleiben. Infolge der geringen Eindringtiefe des Materials der Quantenkonverterschicht 129 für das Primärlicht und der somit bereits nach einem Lichtweg von wenigen Mikrometern (µm) in diesem Material erfolgten Absorption wird auch in dieser Ausführungsform der Abstand zwischen Detektionsebene und Moire-Maske effektiv gering gehalten, da infolge der geringen Eindringtiefe Primärlicht unterschiedlicher, benachbarter Feldpunkte nicht zusammenfallen kann.

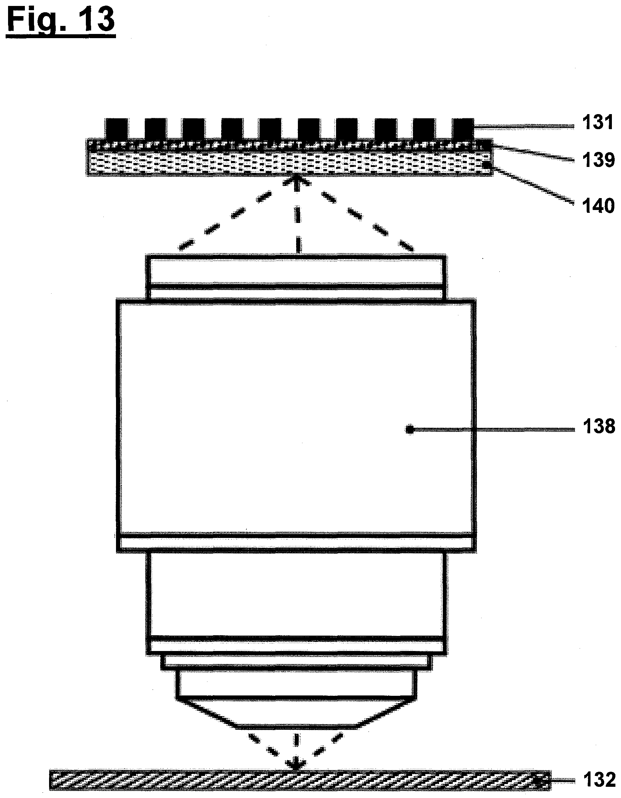

Fig. 13 zeigt eine weitere Ausführungsform, wobei im Vergleich zu Fig. 12 analoge bzw. im Wesentlichen funktionsgleiche Komponenten mit oben "10" erhöhten Bezugsziffern bezeichnet sind.

Bei der Ausführungsform von Fig. 13 ist im Vergleich zu Fig. 12 eine zusätzliche Farbfilterschicht 140 vorgesehen, welche von der Quantenkonverterschicht 139 nicht absorbiertes Licht wenigstens teilweise herausfiltert. Hierdurch kann dem Umstand Rechnung getragen werden, dass bei Verwendung einer vergleichsweise dünnen Quantenkonverterschicht 139 ggf. das verwendete (Primär-)Licht eine Eindringtiefe aufweist, die die Dicke der Quantenkonverterschicht 139 (d.h. den effektiven Abstand zwischen Detektionsebene und Moire-Maske) übersteigt, wobei das nicht umgewandelte Primärlicht hier über die Farbfilterschicht 140 eliminiert werden kann.

In weiteren Ausführungsformen kann eine zusätzliche Schutz- und/oder Antireflexschicht zur Reduzierung unerwünschter Störsignale oder zu Schutzzwecken zwischen Moire-Maske und Quantenkonverterschicht, zwischen Quantenkonverterschicht und Farbfilterschicht und/oder im Strahlengang nach der Farbfilterschicht eingesetzt werden.

Wenn die Erfindung auch anhand spezieller Ausführungsformen beschrieben wurde, erschließen sich für den Fachmann zahlreiche Variationen und alternative Ausführungsformen, z.B. durch Kombination und/oder Austausch von Merkmalen einzelner Ausführungsformen. Dementsprechend versteht es sich für den Fachmann, dass derartige Variationen und alternative Ausführungsformen von der vorliegenden Erfindung mit umfasst sind, und die Reichweite der Erfindung nur im Sinne der beigefügten Patentansprüche beschränkt ist.

## Patentansprüche

1. Vorrichtung zur Moire-Vermessung eines optischen Prüflings, mit
• einer Gitteranordnung aus einem ersten, im optischen Strahlengang vor dem Prüfling positionierbaren Gitter (25, 25', 35, 35') und einem zweiten, im optischen Strahlengang nach dem Prüfling positionierbaren Gitter (11, 11', 11", 41, 51, 61, 71, 81, 91, 101, 111, 121, 131, 141);
• einer Auswerteeinheit mit wenigstens einem Detektor (12, 12', 12", 22, 22', 32, 32', 42, 52, 62, 72, 82, 92, 102, 112, 122, 132, 142) zur Auswertung von durch Überlagerung der beiden Gitter in einer im optischen Strahlengang nach dem zweiten Gitter befindlichen Detektionsebene erzeugten Moire-Strukturen;
**dadurch gekennzeichnet, dass** die Vorrichtung wenigstens eine Aperturblende (14, 14', 14", 24, 24', 34, 34') aufweist, durch welche die nach Lichtaustritt aus dem zweiten Gitter entstandene Lichtverteilung derart bereichsweise abgeschattet werden kann, dass nur Licht einer Untermenge aller Feldpunkte auf dem zweiten Gitter die Detektionsebene erreicht.

2. Vorrichtung nach Anspruch 1, **dadurch gekennzeichnet, dass** die Aperturblende (14, 14', 14", 24, 24', 34, 34') derart ausgestaltet ist, dass die betreffende Untermenge aller Feldpunkte auf dem zweiten Gitter, welche jeweils die Detektionsebene erreicht, variabel einstellbar ist.

3. Vorrichtung nach Anspruch 1 oder 2, **dadurch gekennzeichnet, dass** die Aperturblende (14, 14', 14", 24, 24', 34, 34') durch Verschiebung quer zur Lichtausbreitungsrichtung und/oder durch Verdrehung um eine zur Lichtausbreitungsrichtung parallele Achse verstellbar ist oder dass die Aperturblende (14, 14', 14", 24, 24', 34, 34') aus einer Mehrzahl von Aperturblenden, welche sich hinsichtlich der jeweils in derselben Position bewirkten Abschattung voneinander unterscheiden, auswählbar ist.

4. Vorrichtung nach einem der vorhergehenden Ansprüche, **dadurch gekennzeichnet, dass** die Aperturblende (14, 14', 14", 24, 24', 34, 34') oder deren im optischen Strahlengang erzeugtes Bild von dem zweiten Gitter um weniger als 100µm, insbesondere weniger als 60µm, weiter insbesondere weniger als 10µm, entfernt ist.

5. Vorrichtung nach einem der vorhergehenden Ansprüche, **dadurch gekennzeichnet, dass** die Aperturblende (14, 14') zwischen dem zweiten Gitter (11, 11') und dem Detektor (12, 12') angeordnet ist.

6. Vorrichtung nach einem der vorhergehenden Ansprüche, **dadurch gekennzeichnet, dass** die Detektionsebene einen Abstand zu dem zweiten Gitter von weniger als 100µm, insbesondere weniger als 80µm, weiter insbesondere weniger als 60µm, weiter insbesondere weniger als 40µm, weiter insbesondere weniger als 10µm, weiter insbesondere weniger als 5µm, weiter insbesondere weniger als 1µm, weiter insbesondere weniger als 200nm, aufweist.

7. Vorrichtung nach einem der vorhergehenden Ansprüche, **dadurch gekennzeichnet, dass** der optische Prüfling ein Projektionsobjektiv einer mikrolithographischen Projektionsbelichtungsanlage, insbesondere ausgelegt für einen Betrieb bei einer Arbeitswellenlänge von weniger als 30nm, weiter insbesondere ausgelegt für einen Betrieb bei einer Arbeitswellenlänge von weniger als 15nm, ist.

8. Vorrichtung nach einem der vorhergehenden Ansprüche, **dadurch gekennzeichnet, dass** der Detektor (82) ein Array (85) von Lichtsensoren aufweist.

9. Vorrichtung nach einem der vorhergehenden Ansprüche, **dadurch gekennzeichnet, dass** der Detektor (92, 102) eine faseroptisch an die Detektionsebene gekoppelte Sensoranordnung aufweist.

10. Vorrichtung nach einem der vorhergehenden Ansprüche, **dadurch gekennzeichnet, dass** diese eine Hilfsoptik (118) zur Abbildung einer in der Detektionsebene erhaltenen Lichtverteilung auf den Detektor (112) aufweist.

11. Vorrichtung nach einem der vorhergehenden Ansprüche, **dadurch gekennzeichnet, dass** diese ferner eine Quantenkonverterschicht (129, 139) aufweist, welche als Primärlicht zur Detektionsebene gelangendes Licht eines ersten Wellenlängenbereichs absorbiert und Sekundärlicht eines von dem ersten Wellenlängenbereich verschiedenen zweiten Wellenlängenbereichs emittiert.

12. Vorrichtung nach Anspruch 11, **dadurch gekennzeichnet, dass** die Quantenkonverterschicht (129, 139) in dem ersten Wellenlängenbereich eine Eindringtiefe von weniger als 10µm, insbesondere weniger als 5µm, besitzt.

13. Vorrichtung nach Anspruch 11 oder 12, **dadurch gekennzeichnet, dass** diese ferner eine Farbfilterschicht (140) aufweist, welche von der Quantenkonverterschicht (139) nicht absorbiertes Licht wenigstens teilweise herausfiltert.

14. Verfahren zur Moire-Vermessung eines optischen Prüflings unter Verwendung einer Vorrichtung nach einem der vorhergehenden Ansprüche, wobei über die wenigstens eine Aperturblende (14, 14', 14", 24, 24', 34, 34') in einer Mehrzahl von Messschritten die nach Lichtaustritt aus dem zweiten Gitter entstandene Lichtverteilung derart bereichsweise abgeschattet wird, dass jeweils nur Licht einer Untermenge aller Feldpunkte auf dem zweiten Gitter die Detektionsebene erreicht.

15. Verfahren nach Anspruch 14, **dadurch gekennzeichnet, dass** durch Überführung der Aperturblende in unterschiedliche Messstellungen und/oder durch Austausch der Aperturblende eine Erfassung sämtlicher Feldpunkte auf dem zweiten Gitter in einer sequentiellen Messreihe realisiert wird.

## Claims

1. Apparatus for the moire measurement of an optical test object, comprising
• a grating arrangement made of a first grating (25, 25', 35, 35') which is positionable in the optical beam path upstream of the test object and a second grating (11, 11', 11", 41, 51, 61, 71, 81, 91, 101, 111, 121, 131, 141) which is positionable in the optical beam path downstream of the test object;
• an evaluation unit having at least one detector (12, 12', 12", 22, 22', 32, 32', 42, 52, 62, 72, 82, 92, 102, 112, 122, 132, 142), for evaluating moire structures produced by superposition of the two gratings in a detection plane situated downstream of the second grating in the optical beam path;
**characterized in that** the apparatus has at least one aperture stop (14, 14', 14", 24, 24', 34, 34'), by way of which the light distribution which was produced after the light exit from the second grating can be shadowed in a region-wise fashion such that only light of a subset of all field points on the second grating reaches the detection plane.

2. Apparatus according to Claim 1, **characterized in that** the aperture stop (14, 14', 14", 24, 24', 34, 34') is embodied such that the relevant subset of all field points on the second grating which reaches the detection plane in each case is variably settable.

3. Apparatus according to Claim 1 or 2, **characterized in that** the aperture stop (14, 14', 14", 24, 24', 34, 34') is adjustable by way of displacement transversely to the light propagation direction and/or by way of rotation about an axis that is parallel with respect to the light propagation direction, or **in that** the aperture stop (14, 14', 14", 24, 24', 34, 34') is selectable from a plurality of aperture stops that differ from one another with respect to the shadowing that is effected respectively in the same position.

4. Apparatus according to one of the preceding claims, **characterized in that** the aperture stop (14, 14', 14", 24, 24', 34, 34'), or the image produced thereof in the optical beam path, is situated away from the second grating by a distance of less than 100 µm, in particular less than 60 µm, more particularly less than 10 µm.

5. Apparatus according to one of the preceding claims, **characterized in that** the aperture stop (14, 14') is arranged between the second grating (11, 11') and the detector (12, 12').

6. Apparatus according to one of the preceding claims, **characterized in that** the detection plane has a distance from the second grating of less than 100 µm, in particular less than 80 µm, more particularly less than 60 µm, more particularly less than 40 µm, more particularly less than 10 µm, more particularly less than 5 µm, more particularly less than 1 µm, more particularly less than 200 nm.

7. Apparatus according to one of the preceding claims, **characterized in that** the optical test object is a projection lens of a microlithographic projection exposure apparatus, in particular designed for operation at an operating wavelength of less than 30 nm, more particularly designed for operation at an operating wavelength of less than 15 nm.

8. Apparatus according to one of the preceding claims, **characterized in that** the detector (82) has an array (85) of light sensors.

9. Apparatus according to one of the preceding claims, **characterized in that** the detector (92, 102) has a sensor arrangement which is fiber-optically coupled to the detection plane.

10. Apparatus according to one of the preceding claims, **characterized in that** it has an auxiliary optical unit (118) for imaging a light distribution obtained in the detection plane onto the detector (112) .

11. Apparatus according to one of the preceding claims, **characterized in that** it furthermore has a quantum converter layer (129, 139), which absorbs light of a first wavelength range that reaches the detection plane as primary light and emits secondary light of a second wavelength range, which differs from the first wavelength range.

12. Apparatus according to Claim 11, **characterized in that** the quantum converter layer (129, 139) has in the first wavelength range a penetration depth of less than 10 µm, in particular less than 5 µm.

13. Apparatus according to Claim 11 or 12, **characterized in that** it furthermore has a color filter layer (140), which at least partially filters out light that has not been absorbed by the quantum converter layer (139).

14. Method for the moire measurement of an optical test object using an apparatus according to one of the preceding claims, wherein, by way of the at least one aperture stop (14, 14', 14", 24, 24', 34, 34'), the light distribution which was produced after the light exit from the second grating is shadowed in a region-wise fashion in a plurality of measurement steps such that in each case only light of a subset of all field points on the second grating reaches the detection plane.

15. Method according to Claim 14, **characterized in that** capturing of all field points on the second grating is realized in a sequential measurement series by way of transitioning the aperture stop into different measurement positions and/or by interchanging the aperture stop.

## Revendications

1. Dispositif de mesurage du moiré d'un échantillon optique, comprenant
* un arrangement de réseaux constitué d'un premier réseau (25, 25', 35, 35') positionnable devant l'échantillon dans le trajet de rayon optique et d'un deuxième réseau (11, 11', 11", 41, 51, 61, 71, 81, 91, 101, 111, 121, 131, 141) positionnable après l'échantillon dans le trajet de rayon optique ;
* une unité d'interprétation comprenant au moins un détecteur (12, 12', 12", 22, 22', 32, 32', 42, 52, 62, 72, 82, 92, 102, 112, 122, 132, 142) destinée à interpréter des structures de moiré générées par la superposition des deux réseaux dans un plan de détection qui se trouve après le deuxième réseau dans le trajet de rayon optique ;
**caractérisé en ce que** le dispositif possède au moins un diaphragme (14, 14', 14", 24, 24', 34, 34') par lequel la distribution lumineuse produite après la sortie de la lumière du deuxième réseau peut être obscurcie dans certaines zones de telle sorte que seule la lumière d'un sous-ensemble de tous les points de champ sur le deuxième réseau atteint le plan de détection.

2. Dispositif selon la revendication 1, **caractérisé en ce que** le diaphragme (14, 14', 14", 24, 24', 34, 34') est configuré de telle sorte que le sous-ensemble concerné de tous les points de champ sur le deuxième réseau qui atteignent respectivement le plan de détection est réglable de manière variable.

3. Dispositif selon la revendication 1 ou 2, **caractérisé en ce que** le diaphragme (14, 14', 14", 24, 24', 34, 34') peut être positionné par coulissement transversalment par rapport au sens de propagation de la lumière et/ou par rotation autour d'un axe parallèle au sens de propagation de la lumière, ou **en ce que** le diaphragme (14, 14', 14", 24, 24', 34, 34') peut être sélectionné parmi une pluralité de diaphragmes qui se différencient les uns des autres du point de vue de l'obscurcissement respectivement produit dans la même position.

4. Dispositif selon l'une des revendications précédentes, **caractérisé en ce que** le diaphragme (14, 14', 14", 24, 24', 34, 34') ou son image générée dans le trajet de rayon optique est éloigné du deuxième réseau de moins de 100 µm, notamment de moins de 60 µm, encore notamment de moins de 10 µm.

5. Dispositif selon l'une des revendications précédentes, **caractérisé en ce que** le diaphragme (14, 14') est disposé entre le deuxième réseau (11, 11') et le détecteur (12, 12').

6. Dispositif selon l'une des revendications précédentes, **caractérisé en ce que** le plan de détection présente, par rapport au deuxième réseau, un écart inférieur à 100 µm, notamment inférieur à 80 µm, encore notamment inférieur à 60 µm, encore notamment inférieur à 40 µm, encore notamment inférieur à 10 µm, encore notamment inférieur à 5 µm, encore notamment inférieur à 1 µm, encore notamment inférieur à 200 nm.

7. Dispositif selon l'une des revendications précédentes, **caractérisé en ce que** l'échantillon optique est un objectif de projection d'un équipement d'éclairage de projection microlithographique, notamment conçu pour un fonctionnement avec une longueur d'onde de travail inférieure à 30 nm, encore notamment conçu pour un fonctionnement avec une longueur d'onde de travail inférieure à 15 nm.

8. Dispositif selon l'une des revendications précédentes, **caractérisé en ce que** le détecteur (82) possède une matrice (85) de capteurs de lumière.

9. Dispositif selon l'une des revendications précédentes, **caractérisé en ce que** le détecteur (92, 102) possède un arrangement de capteurs couplé par fibre optique au plan de détection.

10. Dispositif selon l'une des revendications précédentes, **caractérisé en ce que** celui-ci possède une optique auxiliaire (118) destinée à représenter sur le détecteur (112) une distribution lumineuse obtenue dans le plan de détection.

11. Dispositif selon l'une des revendications précédentes, **caractérisé en ce que** celui-ci possède en outre une couche de convertisseur quantique (129, 139) qui absorbe en tant que lumière primaire la lumière d'une première plage de longueurs d'onde qui parvient au plan de détection et en tant que lumière secondaire une deuxième plage de longueurs d'onde différente de la première plage de longueurs d'onde.

12. Dispositif selon la revendication 11, **caractérisé en ce que** la couche de convertisseur quantique (129, 139) possède, dans la première plage de longueurs d'onde, une profondeur de pénétration inférieure à 10 µm, notamment inférieure à 5 µm.

13. Dispositif selon la revendication 11 ou 12, **caractérisé en ce que** celui-ci possède en outre une couche de filtre coloré (140) qui élimine par filtrage au moins partiellement la lumière non absorbée par la couche de convertisseur quantique (139).

14. Procédé de mesurage du moiré d'un échantillon optique en utilisant un dispositif selon l'une des revendications précédentes, la distribution lumineuse produite après la sortie de la lumière du deuxième réseau étant obscurcie dans certaines zones par le biais de l'au moins un diaphragme (14, 14', 14", 24, 24', 34, 34') dans une pluralité d'étapes de mesure de telle sorte qu'à chaque fois seule la lumière d'un sous-ensemble de tous les points de champ sur le deuxième réseau atteint le plan de détection.

15. Procédé selon la revendication 14, **caractérisé en ce qu'**une acquisition de tous les points de champ sur le deuxième réseau est réalisée dans une série de mesures séquentielle par transfert du diaphragme dans différentes positions de mesure et/ou par remplacement du diaphragme.
